Europäisches Patentamt

European Patent Office

Office européen des brevets

(19)

(11) Numéro de publication : **0 550 317 A1**

## (12) DEMANDE DE BREVET EUROPEEN

(21) Numéro de dépôt : **92403488.7**

(22) Date de dépôt : **21.12.92**

(51) Int. Cl.⁵ : **H01L 21/28, H01L 21/338, H01L 29/60, H01L 29/812**

(30) Priorité : **31.12.91 FR 9116377**

(43) Date de publication de la demande :
**07.07.93 Bulletin 93/27**

(84) Etats contractants désignés :
**DE GB NL**

(71) Demandeur : **THOMSON COMPOSANTS MICROONDES**
**51, Esplanade du Général de Gaulle**
**F-92800 Puteaux (FR)**

(72) Inventeur : **Pacou, Thierry**
**THOMSON-CSF, SCPI BP 329**
**F-92402 Courbevoie Cedex (FR)**
Inventeur : **Arsene-Henry, Patrice**
**THOMSON-CSF, SCPI BP 329**
**F-92402 Courbevoie Cedex (FR)**
Inventeur : **Pham, Ngu Tung**
**THOMSON-CSF, SCPI BP 329**
**F-92402 Courbevoie Cedex (FR)**
Inventeur : **Aubame, Evelyne**
**THOMSON-CSF, SCPI BP 329**
**F-92402 Courbevoie Cedex (FR)**

(74) Mandataire : **Taboureau, James et al**
**THOMSON-CSF, SCPI, B.P. 329, 50, rue Jean-Pierre Timbaud**
**F-92402 Courbevoie Cédex (FR)**

(54) Procédé de réalisation d'un transistor à effet de champ hyperfréquence.

(57) Un transistor de puissance comporte au moins deux couches semiconductrices (2.3) et deux métallisations de source (4) et drain (5).

Un fossé ou recess (26) de drain est réalisé après le recess de grille (14), le dépôt de la grille en T, (15) et le masquage partiel par un diélectrique (17), en utilisant la grille (15) comme masque. Ainsi, la gravure côté drain n'entraîne pas de gravure côté source.

Application aux transistors de puissance, pour lesquels $V_{DS}$ est élevé.

FIG.11

EP 0 550 317 A1

La présente invention concerne un procédé de réalisation d'un transistor à effet de champ à caractéristiques source-drain dissymétriques et ajustables par creusement d'un fossé dans les couches semiconductrices, après dépôt de l'électrode de grille.

Ce procédé est applicable à tous les transistors à effet de champ, quel que soient leurs matériaux semiconducteurs, mais il est plus spécialement dédié aux transistors de puissance sur matériaux du groupe III-V, parmi lesquels GaAs et GaAlAs sont les plus fréquemment utilisés. De façon plus générale, ce procédé est applicable à tous les transistors possédant une couche active et une couche de contact (structure n/n+) et dont le canal est ajusté par "recess". On désigne par le terme "recess" un fossé ou dépression creusé par gravure dans les couches de surface de matériaux semiconducteurs, le plus souvent entre les métallisations de source et drain.

Pour obtenir ou augmenter la puissance contrôlée par un transistor, l'un des moyens connus consiste à utiliser une tension source-drain élevée. En raison des dimensions qui se comptent en micromètres, une tension élevée nécessite un recess large entre source et drain pour éviter le claquage entre ces deux électrodes, mais alors la résistance de source $R_S$ augmente et le gain associé diminue. Il est donc nécessaire d'obtenir des caractéristiques source-drain dissymétriques.

La notion de dissymétrie, au moins en caractéristiques sinon en structure, est en soi connue. On peut l'obtenir par exemple par une méthode d'évaporation côté source, avec une grille en épi, mais la dissymétrie n'est pas ajustable dans ce procédé. Une autre méthode repose sur l'utilisation de plusieurs résines de masquage et d'autoalignement, mais la réalisation de cette méthode n'est pas compatible avec une fabrication industrielle.

Le procédé selon l'invention met en oeuvre des moyens et des méthodes couramment utilisés dans l'industrie des semiconducteurs : à titre d'exemple, la précision nécessaire pour les masquages relatifs au recess de drain n'est pas supérieur à 0.5 micromètre. L'une des caractéristiques de ce procédé est que la réalisation du recess de grille est séparée de celle du recess de drain, qui est effectué après dépôt de la métallisation de grille : la gravure des couches conductrices, côté drain, est pilotée dans le temps, et cette gravure nécessite que la grille soit en T -appelée aussi en champignon (mushroom gate) car la grille sert de masque pour l'ouverture du recess de drain.

De façon plus précise l'invention concerne un procédé de réalisation d'un transistor à effet de champ hyperfréquence, comportant au moins deux métallisations de grille et de drain supportées par au moins deux couches de matériaux semiconducteurs, dont la première constitue le canal du transistor et dont la deuxième constitue la couche dopée de contact, ce procédé étant caractérisé en ce qu'il comporte la gravure d'un premier fossé dit recess de grille dans les deux dites couches avant le dépôt de la dite métallisation.

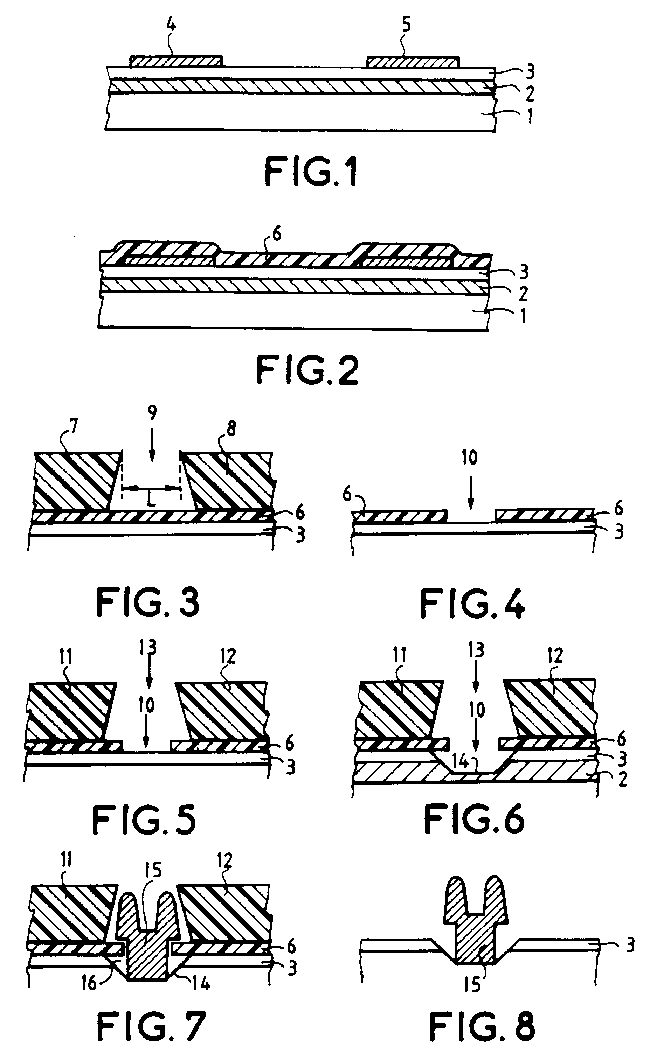

L'invention sera mieux comprise par la description suivante d'un exemple de réalisation, appuyée sur les figures 1 à 11 jointes en annexe qui représentent les diverses étapes du procédé. Toutefois, afin d'être plus précises, les figures subissent un grandissement au fur et à mesure que le procédé avance, nécessitant de montrer des détails. Pour cette raison, les figures 3 à 8 ne représentent que la région de grille, centrale sur les figures 1 et 2, et les figures 9 à 11 ne représentent que la grille et le recess de drain. Le substrat n'est plus représenté à ces échelles dilatées.

Le produit de départ, représenté en figure 1, est un transistor, préférablement hyperfréquence de puissance, qui en est encore au stade collectif, sur tranche de matériau du groupe III-V tel que GaAs ou GaAlAs. Mais ce transistor est néanmoins presque achevé et il comprend, supportées par un substrat 1, au moins une couche active 2, une couche de contact 3 dopée $n^+$, et deux métallisations 4 de source et 5 de drain. D'autres couches ou détails de structure sont possibles, mais n'apportent rien à l'exposé de l'invention.

La première opération, représentée en figure 2, consiste à déposer sur le produit de la figure 1 une couche 6 d'un diélectrique tel que $Si_3 N_4, SiO_2$ ou AlN, sur une épaisseur de 800 à 1200 A° environ.

La gravure du recess de grille nécessite d'abord un masquage (figure 3) au moyen d'une résine 7 + 8 qui, après exposition de préférence à un faisceau électronique, permet d'obtenir une ouverture 9 dont la largeur "L" peut être aussi faible que 0.15 micromètres.

Par des moyens de gravure directionnels, tels que la gravure ionique réactive RIE anisotrope, sous basse pression, une ouverture 10 (figure 4) est gravée dans la couche 6 de diélectrique, à travers l'ouverture 9 du masque de résine 7 + 8. Cette ouverture 10 a même largeur "L" que l'ouverture 9.

La première couche de résine 7 + 8 est dissoute et remplacée (figure 5) par une deuxième couche de résine 11 + 12, qui est à son tour masquée, par moyens électroniques ou optiques, pour obtenir une ouverture 13, axée sur l'ouverture 10 dans la couche de diélectrique. La largeur de l'ouverture 13 dans la résine est de l'ordre de 0.6 micromètres et correspond au futur champignon de la métallisation de grille, tandis que l'ouverture 10 correspond au futur pied de grille, c'est à dire à la longueur de grille, mesurée selon un axe source-drain.

Par gravure chimique, ou sèche en plasma, le recess de grille 14 est creusé, à travers les ouvertures 13 et 10, dans les couches de matériau semiconducteur. Ce recess doit au moins traverser la couche 3 dopée n+, d'autres couches intermédiaire s'il y en a, et atteindre la couche active 2. On sait qu'au cours d'une gravure il y a une légère sous-gravure sous les bords de l'ouverture 10 dans la couche de diélectrique (figure 6).

La métallisation de grille 15 est déposée par des moyens connus, tels que l'évaporation (figure 7). Une partie du métal passe à travers l'ouverture 10 et forme le pied de la grille, fin, mais simultanément une autre partie du métal se dépose sur les bords de l'ouverture 10 et à l'intérieur de l'ouverture 13, de sorte que le champignon de la grille a une forme de "M".

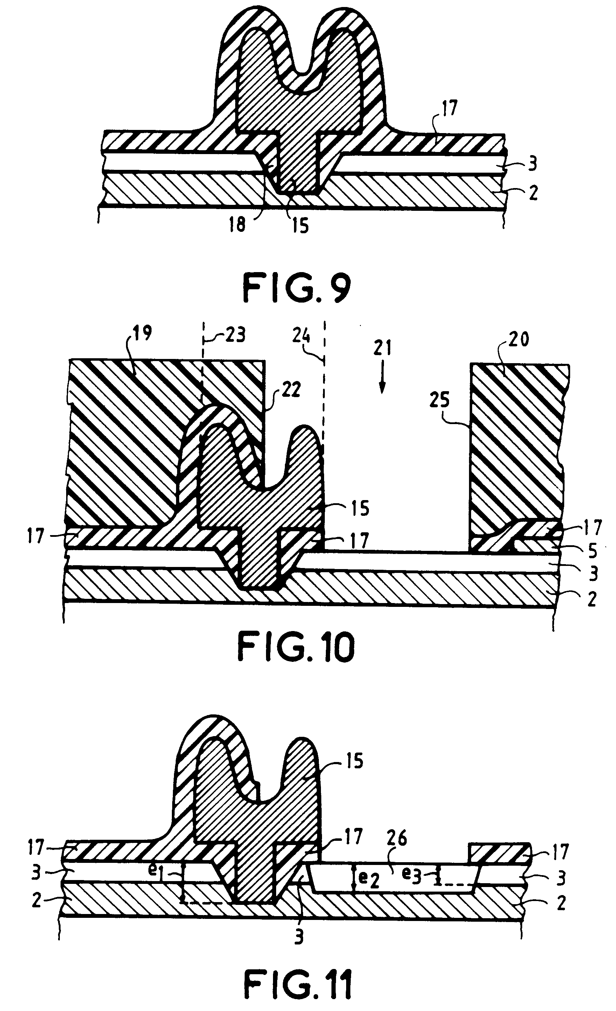

La seconde couche de résine 11 + 12 est dissoute, mais la couche de diélectrique 6 ne peut pas jouer le rôle de passivation du transistor, par ce que les cavités 16 qui existent entre le pied de la grille 15 et les bords du recess de grille 14 font qu'à cet endroit le matériau semiconducteur n'est pas protégé. La figure 8 montre que la couche 6 de $Si_3N_4$, ou de diélectrique est supprimée par gravure sèche à bas dommage (sous faible énergie), pour être remplacée, en figure 9, par une autre couche 17 de diélectrique tel que $Si_3N_4$, sous une épaisseur de l'ordre de 1000 angströms. Cette nouvelle couche 17 a sur la précédente 6 l'avantage de passiver en 18 le canal dans la couche active 2, et de remplir les cavités 16.

Une troisième couche de résine est alors déposée sur la surface du transistor, puis masquée pour y graver une ouverture 21, comme représentée en figure 10. Cette troisième couche de résine est suffisamment épaisse pour recouvrir le champignon de la grille en T 15. La position et les dimensions de l'ouverture 21 correspondent à celles du recess de drain qu'il faut ouvrir dans le corps semiconducteur. Un premier flanc 22 de cette ouverture 21 est à l'aplomb de la grille 15 et, étant donné que c'est le champignon de la grille qui servira de masque, la position du flanc 22 de l'ouverture n'a pas besoin d'être précise, à condition qu'elle soit située entre les deux flancs 23 et 24 du champignon. C'est pourquoi le masquage peut être effectué par des moyens optiques, puisque la largeur du champignon est de l'ordre de 0,6 micromètre. La position du second flanc 25 de l'ouverture 21 est proche de la métallisation de drain 5, et la précision de cette position se satisfait également de moyens de masquage optiques.

Après dissolution de la résine dans l'ouverture 21, la couche de diélectrique 17 qui apparait sur la grille et dans le fond de l'ouverture est gravée par gravure ionique réactive par exemple.

Ainsi est dégagée dans le fond de l'ouverture une surface libre de la couche 3 dopée $n^+$. Elle est gravée par gravure chimique ou ionique réactive anisotrope, de façon à creuser le recess de drain 26 que montre la figure 11. L'opération finale consiste à retirer la troisième résine 19 + 20 par dissolution par exemple : le transistor, qui comportait déjà ses différentes couches constitutives et ses métallisations de source et drain, est achevé.

La profondeur $e_2$ du recess de drain 26 est ajustable par le temps de gravure en se barrit sur le temps nécessaire à la gravure du recess 14 de grille. Si $e_1$ est la profondeur de ce recess de grille et $e_3$ est l'épaisseur de la couche 3 dopée $n^+$, il faut que

$$e_1 > e_2 > e_3$$

Les différents moyens mis en oeuvre mis en oeuvre dans ce procédé, tels que masquage, gravure ionique, évaporation.etc, n'ont pas été détaillés. Ils sont bien connu de l'homme de l'art et ont en commun d'être tous des moyens industriels, dont la mise en oeuvre est courante.

Le procédé décrit permet d'améliorer les performances des transistors de puissance hyperfréquences, en maintenant une résistance de source $R_S$ faible, puisque le recess est étroit côté source, et en augmentant la puissance et le gain de sortie, par augmentation de la tension $V_{DS}$, grâce au recess de drain.

## Revendications

1 - Procédé de réalisation d'un transistor à effet de champ hyperfréquence, comportant au moins deux métallisations de grille (15) et de drain (5) supportées par au moins deux couches de matériaux semiconducteurs, dont la première (2) constitue le canal du transistor et dont la deuxième (3) constitue la couche dopée (n+) de contact, ce procédé étant caractérisé en ce qu'il comporte la gravure d'un premier fossé dit recess (14) de grille dans les deux dites couches (2.3) avant le dépôt de la métallisation de grille (15), puis la gravure d'un second recess (26) de drain après le dépôt de la dite métallisation (15).

2 - Procédé selon la revendication 1, caractérisé en ce qu'il comporte les étapes suivantes :
- dépôt d'une première couche (6) de matériau diélectrique tel que $Si_3 N_4$ sur un transistor dépourvu de métallisation de grille, masquage par une première couche de résine (7 + 8) de façon à définir une première ouverture (9) à l'emplacement de la grille, et gravure dans la couche de diélectrique (6) d'une deuxième ouverture (10),
- dépôt d'une deuxième couche de résine (11 + 12) et masquage de façon à définir une troisième ouverture (13) centrée sur la deuxième ouverture (10) dans le diélectrique (6),
- gravure dans les deux couches (2.3) de matériau semiconducteur d'un fossé, dit recess de grille (14) sur une profondeur ($e_1$) atteignant le canal (2) du transistor,
- dépôt d'une métallisation de grille (15) en T, et suppression de la deuxième couche de résine (11 + 12) et de la première couche diélectrique (6),
- dépôt d'une deuxième couche (17) de matériau diélectrique tel que $Si_3N_4$, et d'une troisième couche de résine (19+ 20),

- masquage de façon à définir dans la dite troisième couche de résine une troisième ouverture (21) dont un premier flan (22) est positionné à l'aplomb de la grille en T (15) et dont un second flan (25) est à promixité de la métallisation de drain (5),
- gravure à travers la troisième ouverture (21) de la deuxième couche (17) diélectrique et du fossé, dit recess de drain (26), dan les deux dites couches (2,3) de matériau semiconducteur, et dissolution de la troisième couche de résine (19 + 20).

**3 -** Procédé selon la revendication 2, caractérisé en ce que, si $e_1$ est la profondeur du recess de grille (14) et $e_3$ est l'épaisseur de la deuxième couche (3) de matériau semiconducteur, la profondeur $e_2$ du recess de drain (26) est définie par :

$$e_1 > e_2 > e_3$$

FIG.1

FIG.2

FIG.3

FIG.4

FIG.5

FIG.6

FIG.7

FIG.8

**FIG. 9**

**FIG. 10**

**FIG. 11**

**Office européen des brevets**

# RAPPORT DE RECHERCHE EUROPEENNE

Numero de la demande

EP 92 40 3488

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 633 100 (MITSUBISHI)<br>* page 4, ligne 14 - page 8, ligne 20; figures 1-4 *<br>--- | 1-3 | H01L21/28<br>H01L21/338<br>H01L29/60<br>H01L29/812 |
| A | PATENT ABSTRACTS OF JAPAN<br>vol. 5, no. 137 (E-72)(809) 29 Août 1981<br>& JP-A-56 071 980 ( MITSUBISHI ) 15 Juin 1981<br>* abrégé *<br>--- | 1-2 | |
| A | ELECTRONICS LETTERS.<br>vol. 26, no. 2, 18 Janvier 1990, STEVENAGE GB<br>pages 152 - 154<br>J.VANBREMEERSCH ET AL. 'Design and realisation of very high performance 0.2 mum gate GaAs MESFETs'<br>* le document en entier *<br>----- | 2 | |

**DOMAINES TECHNIQUES RECHERCHÉS (Int. Cl.5)**

H01L

Le présent rapport a été établi pour toutes les revendications

| Lieu de la recherche | Date d'achèvement de la recherche | Examinateur |
|---|---|---|
| BERLIN | 11 FEVRIER 1993 | MUNNIX S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant